# EUROPEAN PATENT APPLICATION

(11) **EP 1 863 089 A1**
(43) Date of publication of application: **05.12.2007**
(21) Application number: 06425371.9
(22) Date of filing: 31.05.2006
(51) Int. Cl.: H01L 27/105, H01L 27/02, H01L 21/8239, H01L 21/8247

(54) **Non-active electrically structures of integrated electronic circuit**

(71) Applicant: STMicroelectronics S.r.l., 20041 Agrate Brianza (Milano) (IT)
(72) Inventor: Maurelli, Alfonso, 20050 SUlbiate (MI) (IT); Peschiaroli, Daniela, 20131 Milano (IT); Piazza, Fausto, 20041 Agrate Brianza (Milano) (IT); Vigiani, Carlo, 28100 Novara (IT); Zabberoni, Paola, 20052 Monza (Milano) (IT)
(74) Representative: Ferrari, Barbara

(57) **Abstract**

A method is described for manufacturing electrically non active structures of an integrated electronic circuit (1) formed on a semiconductor substrate (7) comprising first electrically active structures (2) which comprise electric components provided with conductive elements (16) of a first height (H1) projecting from said semiconductor substrate (7) and second electrically active structures (3) which comprise electric components provided with conductive elements (20) of a second height (H2) projecting from said semiconductor substrate (7), said first height being different from said second height, the method comprising the steps of:
- introducing, into the integrated electronic circuit (1), electrically non active structures (4) to superficially uniform the integrated electronic circuit (1),
- identifying, between the electrically non active structures (4), a first group (5) of electrically non active structures which is formed by those electrically non active structures comprised in areas (5a) which substantially extend for a predetermined radius (R) around each electric component belonging to the second electrically active structures (3),
- identifying, between the electrically non active structures (4), a second group (6) of electrically non active structures comprising electrically non active structures not belonging to the first group (5) of electrically non active structures,
- forming the electrically non active structures belonging to the first group (5) of electrically non active structures with elements (20a) projecting from the substrate (7) having a height equal to the second height (H2),
- forming the electrically non active structures belonging to the second group (6) of electrically non active structures with elements (16a) projecting from the substrate (7) having a height equal to the first height (H1), the elements (16a, 20a) belonging to the first (5) and second group (6) of electrically non active structures being formed by means of respective photolithographic steps.

## Description

### Field of application

The present invention relates to a method for manufacturing electrically non active structures of an integrated electronic circuit formed on a semiconductor substrate.

More specifically, the invention relates to a method for manufacturing electrically non active structures of an integrated electronic circuit formed on a semiconductor substrate comprising first electrically active structures which comprise electric components provided with conductive elements of a first height projecting from said semiconductor substrate and second electrically active structures which comprise electric components provided with conductive elements of a second height projecting from said semiconductor substrate, said first height being different from said second height.

The invention also relates to an electronic circuit integrated on a semiconductor substrate comprising first electrically active structures which comprise electric components provided with conductive elements of a first height projecting from said semiconductor substrate and second electrically active structures which comprise electric components provided with conductive elements of a second height projecting from said semiconductor substrate, as well as electrically non active structures to superficially uniform said electronic circuit.

The invention particularly, but not exclusively, relates to an electronic circuit comprising memory cells of the Flash type and a low voltage circuitry and the following description is made with reference to this field of application by way of illustration only.

### Prior art

As it is well known, in the design step of electronic circuits integrated on a semiconductor substrate, formed in submicrometric CMOS technologies, the introduction of electrically non active service structures being commonly and hereafter defined as "dummy" structures, is more and more necessary, these structures having the sole scope of taking care of improving the definition, during the manufacturing process, of the electrically active components of an integrated circuit.

These dummy structures, provided in the realisation steps of integrated circuits judged critical for a determined technology, allow to increase the more or less local demsity of electrically active structures which must be integrated on a same semiconductor substrate. These dummy structures, in fact, formed by elements projecting from the semiconductor substrate, for example with polygonal section, reduce, in a significant way, the differences of size and of shape between electrically active structures placed close to very dense circuit areas of structures and those placed inside said areas.

Moreover, the use of removal techniques of layers with tools sensitive to the morphology of the circuit structures, such as the CMP (Chemical Mechanical Polishing), further makes it necessary the introduction of dummy structures, since the presence of these dummy structures also helps to reduce, as much as possible, the altimetric differences between more or less dense areas of electrically active circuits.

Generally, the arrangement, i.e. the layout, of these dummy structures between the electrically active components of an integrated circuit occurs in an automatic way, on the basis of the indications provided by the technology used, employing software instruments normally used by the experts in the field.

US patent No. 7,001,800 entitled "Manufacturing method for non-active electrically structures in order to optimize the definition of active electrically structures in an electronic circuit integrated on a semiconductor substrate and corresponding circuit", to the same Applicant, describes a method for the formation of these dummy structures inside an integrated electronic circuit CI comprising a matrix M of non volatile memory cells and an associated circuitry C, as shown in figure 1. This method provides the formation of these dummy structures in two different photolithographic steps: in the first step the dummy structures D1, shown in figure 2, adjacent to the matrix M and to the circuitry C are defined and in the second step the dummy structures D2, shown in figure 3, non adjacent to the matrix M and to the circuitry C are defined.

It is also known that the dummy structures D1, D2, as those shown in figures 2 and 3, are formed by the same layers forming the memory cells of the matrix M.

It is known that the non volatile memory matrixes M of the Flash type integrated on semiconductor comprise a plurality of non-volatile memory cells organised in a matrix; i.e. the cells are organised in rows, called word lines WL, and columns, called bit lines BL.

Each single non volatile memory cell comprises a MOS transistor wherein the gate electrode, placed above the channel region, is floating, i.e. it has a continuous high impedance towards all the other terminals of the same cell and of the circuit wherein the cell is inserted. The floating gate electrode is generally formed by a first polysilicon layer.

The cell also comprises a second electrode, called control gate, which is capacitively coupled to the floating gate electrode through an intermediate dielectric layer, so called interpoly. This second electrode is driven through suitable control voltages. This control electrode is generally formed by a second polysilicon layer.

Conventionally, the matrix of memory cells is associated with a control circuitry comprising conventional MOS transistors, each having a source region and a drain region separated by a channel region. A gate electrode is then formed on the channel region and insulated therefrom by means of a gate oxide layer. This gate electrode is generally formed by a polysilicon layer.

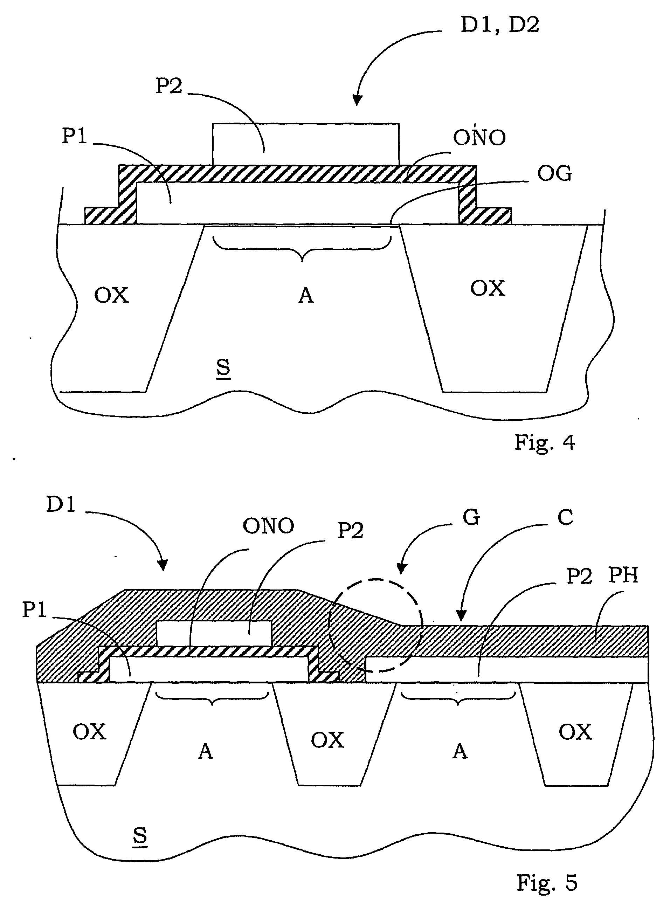

Then, as shown in figure 4, each dummy structure D1, D2 is formed by a stacked structure which comprises a first gate oxide layer OG, a first polysilicon layer P1, an ONO layer and a second polysilicon layer P2 formed on a semiconductor substrate S. This stacked structure is then etched so as to form an element projecting from the semiconductor substrate S above a respective active area A delimited by field oxide regions OX formed on semiconductor substrate S. This stacked structure is then formed by the same layers with which the memory cells of the matrix M are formed, therefore the topology of the integrated circuit CI next to the matrix M is rather regular and allows a correct definition of the gate electrodes of the memory cells.

The solution proposed in the cited document, although allowing to make the areas exposed by the photolithographic masks used to define the structures of the circuitry and of the matrix as much identical as possible, and thus allowing a good definition, at the process level, also of the areas relative to the area occupied by the memory, shows some drawbacks.

In fact, as shown in figure 5, this method for generating and thus forming these dummy structures D1 introduces heavy microloading effects, i.e. it produces regions of different thickness, during the definition step of the polysilicon gate electrodes of the MOS transistors of circuitry C, especially when the sizes of the gate electrodes are submicrometric, for example smaller then or equal to 0,13 µm for low voltage transistors LV.

These microloading effects are exactly due to the fact that the dummy structures D 1 near the active structures of circuitry C are defined with a higher number of layers with respect to those which are used for the structures of circuitry C, i.e. these structures are defined by elements projecting from the semiconductor substrate S of different height: this introduces a sort of step G between the region wherein the LV transistors are formed and the region with dummy structures, which origins undesired effects during the masking and etching step of the gate itself due to a local thinning of a photoresist layer PH which is formed between the regions wherein the LV transistors are formed and the regions with dummy structures, which jeopardises the correct definition of this photoresist layer PH during the successive photolithografic steps.

The technical problem underlying the present invention is that of providing a method for manufacturing dummy structures, having such characteristics as to allow to safeguard a correct definition of the matrix areas and to eliminate the microloading effects still limiting the integrated circuits formed according to the prior art.

### Summary of the invention

The solution idea underlying the present invention is that of identifying dummy structures automatically generated in the layout of an integrated circuit formed on a semiconductor substrate which comprises first electrically active structures which comprise electric components provided with conductive elements of a first height projecting from the semiconductor substrate and second electrically active structures which comprise electric components provided with conductive elements of a second height projecting from the semiconductor substrate, identifying a first group of dummy structures adjacent to the second group of electrically active structures, these dummy structures belonging to the first group of dummy structures being provided with elements projecting from the semiconductor substrate having a height equal to the second height. The dummy structures which do not belong to the first group of dummy structures are instead provided with elements projecting from the semiconductor substrate having a height equal to the first height.

Advantageously, these dummy structures belonging to the first group of dummy structures are defined and formed in the same process steps in which the second electrically active structures are defined and formed, while the remaining dummy structures are defined and formed in the same process steps in which the first electrically active structures are defined and formed.

On the basis of this solution idea the technical problem is solved by a method as previously indicated and defined by the characterising part of claim 1.

The problem is also solved by an integrated circuit as previously indicated and defined by the characterising part of claim 9.

The characteristics and the advantages of the method according to the invention will be apparent from the following description of an embodiment thereof given by way of indicative and non limiting example with reference to the annexed drawings.

### Brief description of the drawings

In these drawings:

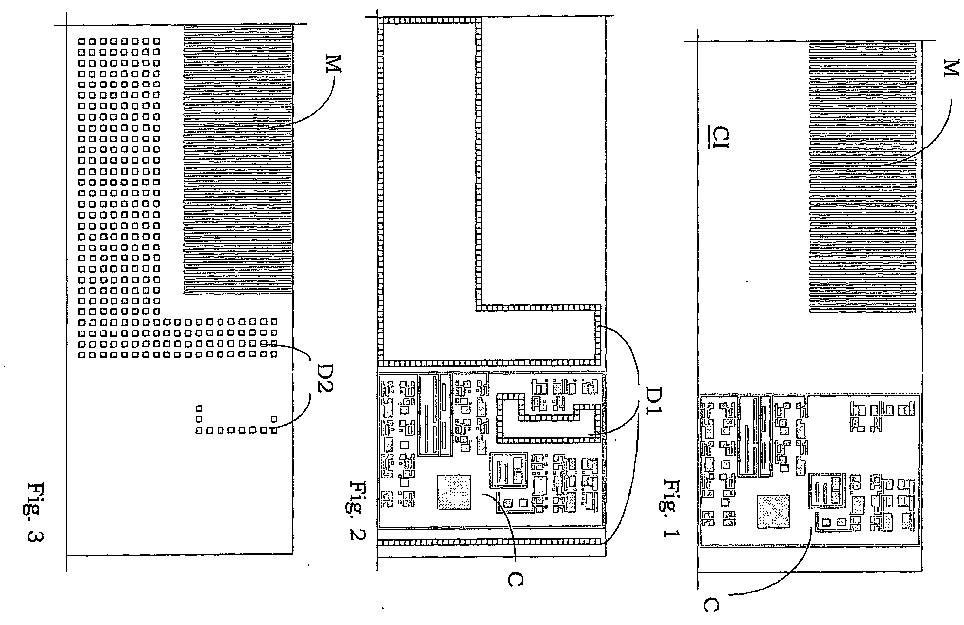

- figure 1 shows an example of layout of an integrated circuit, at the active area level, comprising a portion of a flash non volatile memory matrix and a circuitry portion,
- figure 2 shows the layout of figure 1 wherein the dummy structures adjacent to the flash non volatile memory matrix and to the circuitry have been identified,
- figure 3 shows the layout of figure 1 wherein the dummy structures non adjacent to the flash non volatile memory matrix and to the circuitry have been identified,
- figure 4 shows a vertical section of a dummy structure formed according to the prior art,
- figure 5 shows a vertical section of a portion of the integrated circuit of figure 1 wherein dummy structures of the known type have been described,

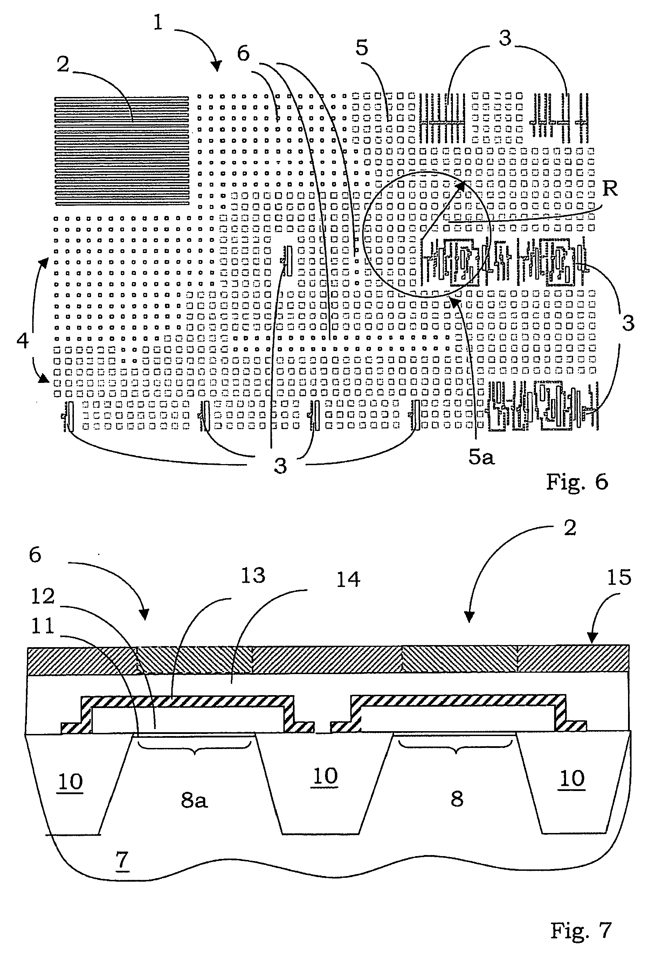

- figure 6 shows an example of layout of an integrated circuit comprising a portion of flash non volatile memory matrix and circuitry portions wherein two different areas have been identified wherein, through two distinct process steps, two different groups of dummy structures are to be defined according to the present invention,

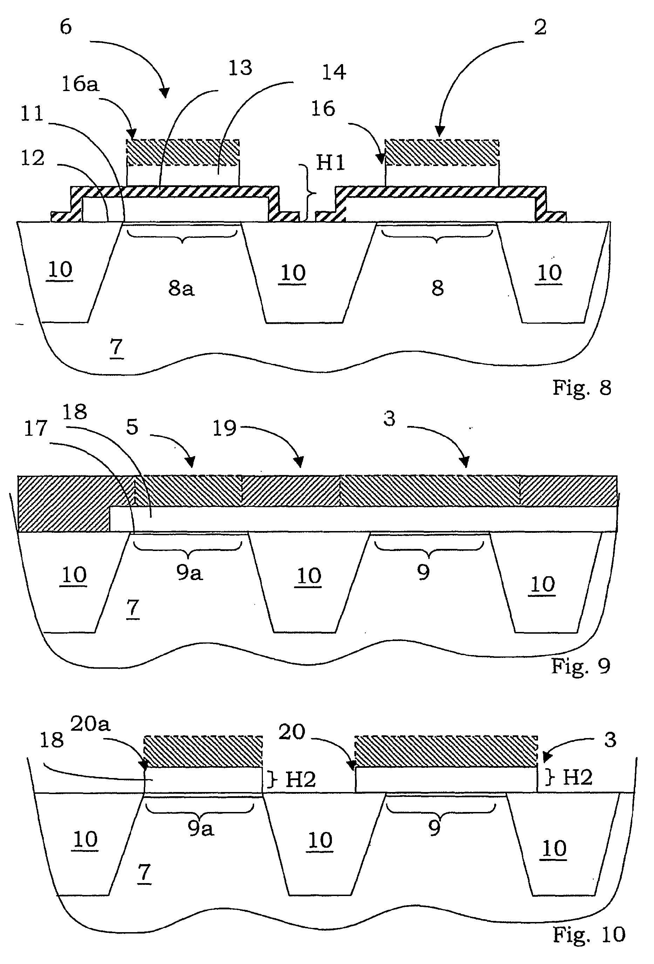

- figures 7 and 8 show vertical section of a portion of the integrated circuit of figure 6 wherein dummy structures adjacent to memory cells during some steps of the method according to the invention have been formed,
- figures 9 and 10 show vertical sections of a portion of the integrated circuit of figure 6 wherein dummy structures adjacent to transistors of the circuitry during some steps of the method according the invention have been formed,

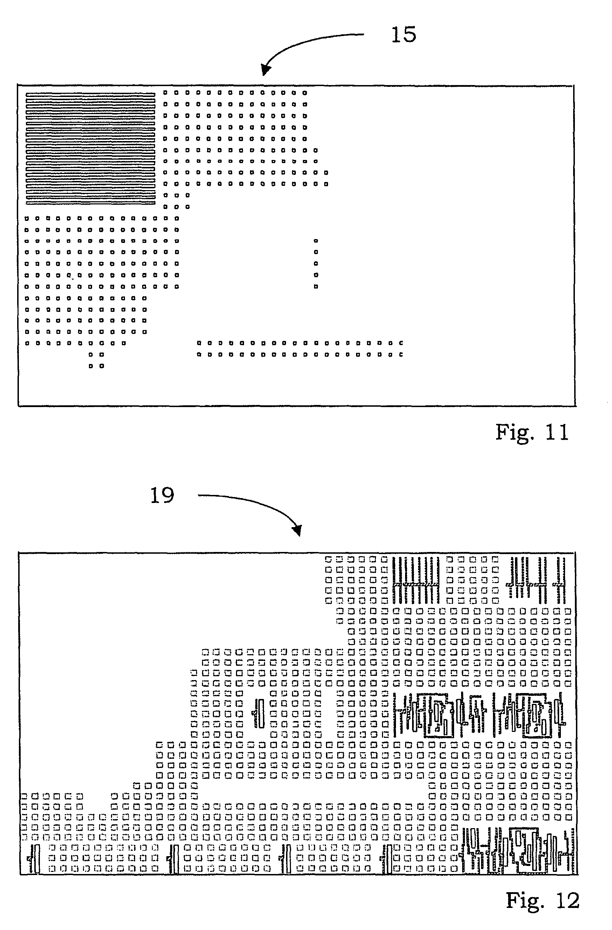

- figures 11 and 12 show two photolithografic masks wherein geometric shapes are etched for forming gate electrodes of electrically active structures and elements projecting from the substrate of electrically non active structures which are comprised in the integrated electronic circuit 1 of figure 6.

### Detailed description

With reference to figures 6 to 10, a method is described for manufacturing electrically non active structures of an integrated electronic circuit formed on a semiconductor substrate.

The process steps described hereafter do not form a complete process flow for the manufacturing of integrated circuit. The present invention can be put into practice together with the manufacturing techniques of integrated circuits currently used in the field, and in the description only those process steps being commonly used and necessary for the comprehension of the present invention are included.

The figures showing transversal sections of portions of an integrated circuit during the manufacturing are not drawn to scale, but they are instead drawn so as to show the important characteristics of the invention.

In particular, with reference to figure 6, the composition is shown of two photolithografic masks wherein the geometric shapes are etched for forming gate electrodes of circuit structures which are comprised in an integrated electronic circuit 1. In particular, this integrated electronic circuit 1 comprises first electrically active structures 2, which comprise electric components having conductor elements 16 projecting from a semiconductor substrate 7 of a first height H1, such as for example memory cells of a matrix of memory cells of the FLASH type and second electrically active structures 3, which comprise electric components having conductor elements 20 projecting from a semiconductor substrate 7 of a second height H2, such as for example transistors of the MOS type, diodes, resistances or capacitors.

For a correct implementation of the method according to the invention, nothing forbids that, among the second electrically active structures 3, electric components are comprised having conductor elements projecting from the semiconductor substrate 7 of a height being different from the second height H2.

As it has already been said with reference to the prior art, electrically non active or dummy structures 4 are introduced into the integrated electronic circuit 1. The identification step of the positions in which these electrically non active structures 4 will be formed inside the integrated electronic circuit 1 usually occurs through an analysis of the electrically active structures present in the integrated electronic circuit 1 and the successive calculation (layer by layer of drawing) of the density of the electrically active structures present on the semiconductor substrate 7. In case this density is lower than what established by the technology, the automatic insertion of these dummy structures 4 is provided inside the empty portions of the integrated electronic circuit 1, so as to reach a desired density.

In the method according to the invention, a first group 5 of dummy structures is then defined which is formed by those dummy structures comprised in areas 5a which substantially extend for a radius R around each electric component of the second electrically active structures 3 and a second group 6 of dummy structures comprising dummy structures non belonging to the first group 5 of dummy structures.

Advantageously, the first group 5 of dummy structures is defined, at the preparation of the masks, simultaneously with the second electrically active structures 3, while the second group of dummy structures 6 is defined simultaneously with the first electrically active structures 2.

Advantageously according to the invention, each dummy structure belonging to the first group 5 of dummy structures is formed at least by the same number of conductive layers forming the second electrically active structures 3, for example a single polysilicon layer, while each dummy structure belonging to the second group 6 of dummy structures is formed at least by the same number of conductive layers forming the first electrically active structures 2, for example two polysilicon layers.

In other words, each dummy structure belonging to the first group 5 of dummy structures is formed by an element 20a projecting from the substrate 7 having a height equal to the second height H2, while each dummy structure belonging to the second group 6 of dummy structures is formed by an element 16a projecting from the substrate 7 having a height equal to the first height H 1.

Advantageously, the value of the radius R must be chosen so that each component belonging to the second electrically active structures 3 is surrounded by a sufficient number of dummy structures belonging to the first group 5 of dummy structures, so as to efficiently reduce the microloading effects in the portions of integrated electronic circuit 1 being arranged between the second electrically active structures 3 and the first group 5 of dummy structures.

Advantageously, the radius R must be chosen so that the number of dummy structures belonging to the second group 6 of dummy structures is high enough so that the amount of area exposed by the photolithografic mask used to form this second group 6 of dummy structures, when these dummy structures are formed together with the first electrically active structures 2, is not excessively low.

In fact, each dummy structure belonging to the first group 5 of dummy structure being formed at least by the same number of conductive layers forming the second electrically active structures 3, the surface of the integrated electronic circuit 1 around these second electrically active structures 3 is rather uniform.

In a preferred embodiment, all the dummy structures comprised in the areas 5a belong to the first group 5 of dummy structures.

According to the invention an electronic circuit 1 is then defined being integrated on a semiconductor substrate 7 and comprising first electrically active structures 2 which comprise electric components provided with conductive elements 16 of a first height H1 projecting from the semiconductor substrate 7 and second electrically active structures 3 which comprise electric components provided with conductive elements 20 of a second height H2 projecting from the semiconductor substrate 7, as well as electrically non active structures 4 to superficially uniform the electronic circuit, wherein the electrically non active areas 4 comprise:
- a first group 5 of electrically non active structures, comprised in areas 5a which substantially extend for a predetermined radius R around each electric component belonging to the second electrically active structures 3, which are provided with elements 20a projecting from the substrate 7 having a height equal to the second height H2, and
- a second group 6 of electrically non active structures, comprising electrically non active structures not belonging to the first group 5 of electrically non active structures, which are provided with elements 16a projecting from the substrate 7 having a height equal to the first height H1.

To the purpose of making the advantages of the method according to the invention clearer, an embodiment thereof is now described, as non limiting example.

In particular, a method is described for manufacturing an integrated electronic circuit 1 on a semiconductor substrate 7 comprising a matrix 2 of non volatile memory cells of the Flash type and an associated circuitry comprising at least one plurality of MOS transistors 3, as well as dummy structures 4 to superficially uniform the electronic circuit 1.

In particular, on a semiconductor substrate 7 active areas 8 are formed whereon the memory cells 2 are formed and active areas 9 are formed whereon the transistors 3 are formed.

The conventional process steps to form these active areas provide:
- forming, in cascade, a silicon oxide layer and a silicon nitride layer on the semiconductor substrate 7,
- selectively removing the silicon nitride and silicon oxide layers by means of a photolithografic technique which provides the use of a first photolithografic mask, for forming active areas 8 wherein the memory cells 2 are formed,
- removing a part of semiconductor substrate by using the same first photolithografic mask forming trenches which separate different non removed regions of the nitride layer.

The process steps here described for forming the active areas 8 are then repeated to manufacture the active areas 9 of the transistors 3, using a second photolithografic mask.

The process goes on in a known way with the steps of:
- oxidising the surface of the exposed semiconductor substrate 7 and filling in the trenches in the semiconductor substrate 7 with a field oxide layer 10,
- planarising the surface by means of CMP technique (chemical mechanical polishing) for removing the dielectric layer formed above the silicon nitride layer,
- removing the silicon nitride layer and the underlying oxide layer for uncovering the surface of the active areas 8 and the active areas 9.

Moreover, so as to increase the amount of semiconductor substrate 7 to be removed for manufacturing the active areas 8, 9, active areas are defined for the dummy structures 4 as well.

According to the invention, these dummy structures 4 are divided into a first group 5 of dummy structures which is formed by dummy structures comprised in areas 5a which substantially extend for a radius R around each transistors 3 and a second group 6 of dummy structures comprising dummy structures not belonging to the first group 5 of dummy structures.

In a first particularly advantageous embodiment of the invention, in the same process steps in which the active areas 9 of the transistors 3 are formed, active areas 9a of the first group 5 of dummy structures are formed.

In other words, the second photolithographic mask provides a plurality of openings to form the active areas 9 of the transistors 3 and a plurality of openings to form the active areas 9a of the first group 5 of dummy structures.

Moreover, the active areas 8a of the second group 5 of dummy structures are formed in the same process steps in which the active areas 8 of the memory cells 2 are formed.

Therefore, the first photolithografic mask provides a plurality of openings to form the active areas 8 of the memory cells 2 and a plurality of openings to form the active areas 8a of the second group 6 of dummy structures.

In an embodiment of the method according to the invention, the sizes of the active areas 8a of the second group 6 of dummy structures are smaller than the sizes of the active areas 9a of the first group 5 of dummy structures.

This embodiment is particularly advantageous when the percentage of dummy structures of the second group 6 of dummy structures, i.e. those defined at the first mask relative to the memory cells 2 of the matrix, is rather low ad could introduce problems in the etching step of the semiconductor substrate 7 caused by a small exposed area of the first mask.

The method provides to form, above the active areas 8, 8a a first multilayer structure comprising a first dielectric layer 11, for example of active oxide, a first conductive layer 12, for example of polysilicon, a second dielectric layer 13, for example interpoly oxide and a second conductive layer 14, for example of polysilicon.

By using conventional photolithographic techniques which provide the use of at least one third photolithografic mask 15 formed by a resist layer also indicated with reference number 15, in the first multilayer structure gate electrodes 16 of the memory cells 2 are defined. In particular, as shown in figures 7 and 8, through the third mask 15, the second conductive layer 14 is etched.

Advantageously according to the invention, together with the gate electrodes 16 of the memory cells 2 having a first height H1, elements 16a projecting from the semiconductor substrate 7 having height equal to the first height H1 belonging to the second group 6 of dummy structures are defined. In this case, the layout of the third photolithographic mask 15 is shown in figure 11.

Advantageously according to the invention, the elements 16a with height H1 are formed in the same process steps in which the gate electrodes 16 are formed, therefore the elements 16a and the gate electrodes 16 are formed by the same number of layers.

According to the invention, the method provides to form, above the active areas 9, 9a of the first group 5 of dummy structures and of the transistors 3, a second multilayer structure comprising a third dielectric layer 17, for example of active oxide also known as tunnel oxide, a third conductive layer 18, for example of polysilicon.

Advantageously, the third conductive layer 18 is simultaneously formed with the second conductive layer 12 or with the first conductive layer 14 of the cells of the matrix.

By using convention photolithographic techniques which provide the use of at least one fourth photolithographic mask 19, formed by a resist layer also indicated with reference number 19, in the second multilayer structure gate electrodes 20 of the transistors 3 are defined, as shown in figures 9 and 10.

Advantageously according to the invention, together with the gate electrodes 20 of the transistors 3 having a second height H2, elements 20a projecting from the semiconductor substrate 7 having height equal to the second height H2 belonging to the first group 5 of dummy structures are defined. In this case, the layout of the fourth photolithographic mask 19 is shown in figure 12.

In particular, the elements 20a of height H2 are formed in the same process steps in which the gate electrodes 20 are formed, therefore the elements 20a and the gate electrodes 20 are formed by the same number of layers.

According to the invention, the elements 16a of height H1 and the elements 20a of height H2 are then defined by means of two distinct steps.

It can be noted that in the areas of the integrated circuit 1 near the transistors 3 the conformation of the photoresist layer 19 is more planar with respect to the conformation of the photorestist layer PH which was deposited on known structures, as shown in figure 5, thus reducing the microloading effects caused by the different photoresist local thickness.

Although in the description reference has been made to a process for the simultaneous formation of a memory matrix and a circuitry region in the same integrated circuit formed on a semiconductor substrate, the method according to the invention can be equally applied to electrically active structures, integrated in an integrated circuit, comprising conductive elements projecting from the semiconductor substrate with different height H 1 and H2.

In conclusion, the method according to the invention allows to define, in a differential way, at the mask manufacturing level, and consequent realisation, on a semiconductor substrate 7, of dummy structures 4, so as to define most of these structures 6 simultaneously with the definition of the matrix 2 active area, however without jeopardising the correct realisation of the electrodes 20 of the circuitry due to the microloading effects.

## Claims

1. Method for manufacturing electrically non active structures of an integrated electronic circuit (1) formed on a semiconductor substrate (7) comprising first electrically active structures (2) which comprise electric components provided with conductive elements (16) of a first height (H1) projecting from said semiconductor substrate (7) and second electrically active structures (3) which comprise electric components provided with conductive elements (20) of a second height (H2) projecting from said semiconductor substrate (7), said first height being different from said second height, the method comprising the steps of:
- introducing, into said integrated electronic circuit (1), electrically non active structures (4) to superficially uniform said integrated electronic circuit (1), the method being **characterised in that** it comprises the following further steps:
- identifying, between said electrically non active structures (4), a first group (5) of electrically non active structures which is formed by those electrically non active structures comprised in areas (5a) which substantially extend for a predetermined radius (R) around each electric component belonging to said second electrically active structures (3),
- identifying, between said electrically non active structures (4), a second group (6) of electrically non active structures comprising electrically non active structures not belonging to the first group (5) of electrically non active structures,
- forming said electrically non active structures belonging to said first group (5) of electrically non active structures with elements (20a) projecting from said substrate (7) having a height equal to said second height (H2),
- forming said electrically non active structures belonging to said second group (6) of electrically non active structures with elements (16a) projecting from said substrate (7) having a height equal to said first height (H1), said elements (16a, 20a) belonging to said first (5) and second group (6) of electrically non active structures being formed by means of respective photolithographic steps.

2. Method for manufacturing electrically non active structures according to claim 1, **characterised in that** said first group (5) of electrically non active structures is defined and formed together with said second electrically active structures (3).

3. Method for manufacturing electrically non active structures according to claim 1, **characterised in that** said second group (6) of electrically non active structures is defined and formed together with said first electrically active structures (2).

4. Method for manufacturing electrically non active structures according to claim 2, **characterised in that** each element (20a) belonging to said first group (5) of electrically non active structures is formed by at least a same number of conductive layers forming said conductive elements (20) belonging to said second electrically active structures (3).

5. Method for manufacturing electrically non active structures according to claim 3, **characterised in that** each element (16a) belonging to said second group (5) of electrically non active structures is formed by at least a same number of conductive layers forming said elements (16) belonging to said first electrically active structures (2).

6. Method for manufacturing electrically non active structures according to claim 3, **characterised in that** said first electrically active structures (2) are formed by floating gate transistors of a matrix of non volatile memory cells.

7. Method for manufacturing electrically non active structures according to claim 2, **characterised in that** said second electrically active structures (3) comprise transistors of the MOS type of a circuitry associated with a matrix of non volatile memory cells.

8. Method for manufacturing electrically non active structures according to claim 1, **characterised in that** said elements (16a) belonging to said second group (6) of electrically non active structures can be formed in active areas (8a) of smaller sizes of active areas (9a) whereon said elements (20a) belonging to said first group (6) of electrically non active structures are formed.

9. Electronic circuit (1) integrated on a semiconductor substrate (7) comprising first electrically active structures (2) which comprise electric components provided with conductive elements (16) of a first height (H1) projecting from said semiconductor substrate (7) and second electrically active structures (3) which comprise electric components provided with conductive elements (20) of a second height (H2) projecting from said semiconductor substrate (7), as well as electrically non active structures (4) to superficially uniform said electronic circuit, **characterised in that** said electrically non active structures (4) comprise:
- a first group (5) of electrically non active structures, comprised in areas (5a) which extend substantially for a predetermined radius (R) around each electric component belonging to said second electrically active structures (3), which are provided with elements (20a) projecting from said substrate (7) having a height equal to said second height (H2), and
- a second group (6) of electrically non active structures, comprising electrically non active structures not belonging to the first group (5) of electrically non active structures, which are provided with elements (16a) projecting from said substrate (7) having a height equal to said first height (H1).

10. Electronic circuit (1) integrated on a semiconductor substrate (7) according to claim 9, **characterised in that** each element (20a) belonging to said first group (5) of electrically non active structures is formed by the same number of conductive layers forming said conductive elements (20) belonging to said second electrically active structures (3).

11. Electronic circuit (1) integrated on a semiconductor substrate (7) according to claim 9, **characterised in that** each element (16a) belonging to said second group (5) of electrically non active structures is formed by at least a same number of conductive layers forming said conductive elements (16) belonging to said first electrically active structures (2).

12. Electronic circuit (1) integrated on a semiconductor substrate (7) according to claim 9, **characterised in that** said first electrically active structures (2) comprise non volatile memory cells.

13. Electronic circuit (1) integrated on a semiconductor substrate (7) according to claim 9, **characterised in that** said second electrically active structures (3) comprise transistors of the MOS type of a circuitry associated with a matrix of non volatile memory cells.

14. Electronic circuit (1) integrated on a semiconductor substrate (7) according to claim 9, **characterised in that** said first electrically active structures (6) are close to each other and **in that** said second electrically active structures (7) are spaced from each other.
